# EUROPÄISCHE PATENTSCHRIFT

(11) **EP 0 656 659 B1**
(45) Veröffentlichungstag und Bekanntmachung des Hinweises auf die Patenterteilung: **06.03.2002**
(21) Anmeldenummer: 94119073.8
(22) Anmeldetag: 02.12.1994
(51) Int. Cl.: H01L 27/02

(54) **ESD-Schutzstruktur für integrierte Schaltungen**
ESD protection structure for integrated circuits
Structure de protection ESD pour circuit intégrés

(30) Priorität: 02.12.1993 DE 4341170
(43) Veröffentlichungstag der Anmeldung: 07.06.1995
(73) Patentinhaber: Infineon Technologies AG, 81669 München (DE)
(72) Erfinder: Terletzki, Hartmud, Dipl.-Ing., D-85521 Ottobrunn (DE); Guggenmos, Xaver, Dipl.-Ing., D-85221 Dachau (DE)
(74) Vertreter: Zedlitz, Peter, Dipl.-Inf.

(56) Entgegenhaltungen:
- EP-A- 0 371 663
- EP-A- 0 451 904
- US-A- 5 157 573
- US-A- 5 248 892

## Beschreibung

Die Erfindung betrifft eine Schutzstruktur gegen elektrostatische Entladungen für integrierte Halbleiterscnaltungen.

Bei Fertigung und Handhabung von integrierten Schaltungen können elektrostatische Entladungen an den Anschlüssen der Halbleiterbauteile auftreten. Bei Überschreitung der Belastungsgrenze der betroffenen Schaltungsteile der integrierten Schaltung kann Zerstörung auftreten. Bei in MOS-Technologie hergestellten Bauelementen sind insbesondere die Gateoxide und Diffusionsgebiete der Ein- und Ausgangstransistoren gegen Überspannungen empfindlich. Bereits bei weniger als 20V kann Zerstörung auftreten.

Zum Schutz vor elektrostatischen Entladungen (ESD: electro-static discharge) sind Schutzmaßnahmen vorgesehen, um die Festigkeit gegen elektrostatische Überspannungen zu erhöhen. Zwischen einen Ein- oder Ausgang und ein Versorgungspotential sind Schutzelemente geschaltet, die bei Überschreiten einer Schwellenspannung leitend werden und einen Spannungsimpuls zum Versorgungspotential ableiten. Insbesondere bei Eingangsanschlüssen sind solche Schutzelemente wichtig, da das Transistorgate eines Eingangstransistors direkt mit dem Eingangsanschluß verbunden sein kann. Bei Ausgangsanschlüssen kann als Schutzelement auch ein zwischen Ausgangsanschluß und Versorgungspotential liegender Schalttransistor dienen.

Zur Herstellung der integrierten Schaltungen können Silizide verwendet werden, die beispielsweise auf Dotierungsgebieten von Transistoren, Gategebieten und Polysiliziumleiterbahnen aufgebracht sind. Silizide sind Verbindungen von Silizium mit Metallen, wie z. B. Wolfram, Tantal, Platin, ... Durch die Verwendung von Siliziden wird der Serienwiderstand der Diffusionsgebiete erheblich verringert. Dies hat für ESD-Schutzstrukturen zur Folge, daß aufgrund von Inhomogenitäten bei der Stromführung während eines Entladeimpulses lokale Strompfade gebildet werden, deren Stromdichte derart hoch ist, daß die Schutzschaltungen selbst zerstört werden. Die Spannungsfestigkeit der integrierten Schaltung gegen Überspannungen an Ein- und Ausgangsanschlüssen ist somit erheblich verringert.

Zur Abhilfe wurde bisher die Silizidschicht an den entsprechenden Stellen der ESD-Schutzschaltungen ausgespart. Dies erfordert jedoch eine zusätzliche Maske mit den entsprechenden fotolithografischen Schritten. Dadurch wird der Fertigungsaufwand zur Herstellung der integrierten Schaltung einhergehend mit den damit verbundenen Kosten erhöht und die Ausbeute verringert. Es sind andere Lösungen bekannt, bei denen die Drain- und Source-Gebiete als vergrabene Schicht an das Gate geführt werden. Auch hier ist ein zusätzlicher Prozeßaufwand notwendig.

Aus der US-A-5,248,892 ist eine gattungsgemäße Schutzstruktur gegen elektrostatische Entladung für integrierte Halbleiterschaltung beschrieben. Die Schutzstruktur weist ein Halbleiterbauteil, das zwischen dem Anschluß einer integrierten Schaltung und einem Anschluß für ein Versorgungspotential geschaltet ist und ein Dotierungsgebiet auf. Ferner weist die Schutzstruktur einen Widerstand, der als Wannendotierungsgebiet realisiert ist und der zwischen dem Dotierungsgebiet und dem Anschluß der integrierten Schaltung geschaltet ist, auf.

Die Aufgabe der vorliegenden Erfindung ist es, eine ESD-Schutzstruktur für integrierte Schaltungen anzugeben, die eine hohe Spannungsfestigkeit aufweist und ohne zusätzliche Prozeßschritte hergestellt werden kann. Die Schutzstruktur soll insbesondere auch für integrierte Schaltungen mit Silizidschicht geeignet sein.

Diese Aufgabe wird durch eine Schutzstruktur gegen elektrostatische Entladungen für integrierte Schaltungen mit den Merkmalen des Patentanspruchs 1 gelöst.

Die Erfindung wird im folgenden anhand der Figuren der Zeichnung erläutert. Es zeigen
Figur 1 eine erfindungsgemäße Ausgangsschutzstruktur,
Figur 2 eine weitere Ausgangsschutzstruktur,
Figur 3 Schaltungsdiagramme verschiedener Ausführungsformen,
Figur 4 eine Eingangsschutzstruktur und
Figur 5 eine Schutzstruktur in Aufsicht.

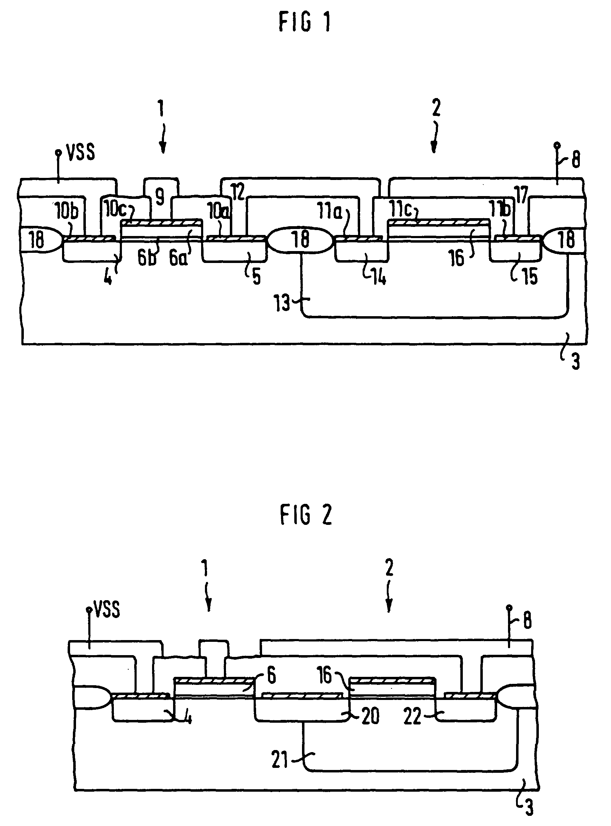

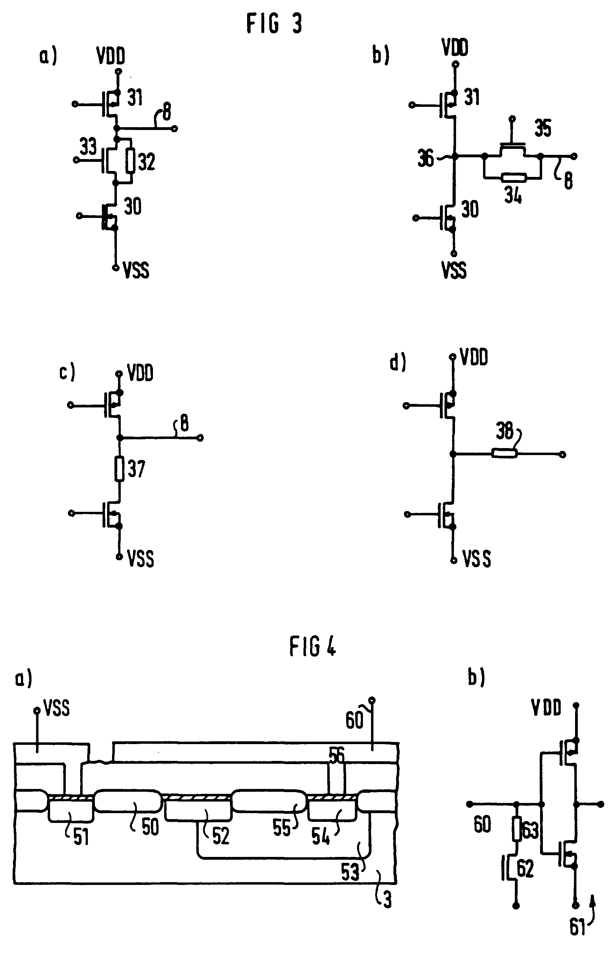

Eine erfindungsgemäße Schutzstruktur kann gemäß Figur 1 an einem Ausgang einer integrierten Schaltung angeordnet werden. Die enthält einen MOS-Transistor 1 und einen als Wannenwiderstand realisierten Widerstand 2. Der Transistor 1 ist außerdem ein Teil einer aktiven Ausgangsschaltung, beispielsweise eines Inverters (Figur 3). Der Transistor ist in einem Halbleitersubstrat 3, das beispielsweise p-dotiert ist, angeordnet. Der Transistor 1 ist folglich vom n-Leitungstyp. Das Sourcedotierungsgebiet 4 ist über einen Metallkontakt mit einem Versorgungspotential VSS (Masse) verbunden. Ein Drainanschluß 5 des Transistors 1 ist über den Widerstand 2 an den Ausgangsanschluß 8 angeschlossen. Zwischen den Drain- und Sourcegebieten 5 bzw. 4 des Transistors 1 ist dessen Gate-Elektrode 6 angeordnet, die aus einem Gateoxid 6a und darüberliegendem Polysilizium 6b besteht. Die Gate-Elektrode ist über einen Metallkontakt 9 elektrisch anschließbar. Auf die Drain- und Sourcediffusionsgebiete des Transistors und das Polysiliziumgate ist unmittelbar eine Silizidschicht 10a, 10b, 10c aufgebracht. Durch die Silizidschicht werden die Schalteigenschaften des Transistors verbessert. Es wird insbesondere der Widerstand von Dotierungsgebieten und Polysilizium verringert. Der Wannenwiderstand 2, der zwischen das Draingebiet und den Ausgangsanschluß 8 geschaltet ist, umfaßt eine Wanne 13 vom n-Leitungstyp, je ein Dotierungsgebiet 14, 15 vom n-Leitungstyp zum Anschluß an das Draingebiet 5 des Transistors 1 bzw. an den Ausgangsanschluß 8 und ein zwischen den Anschlußgebieten 14, 15 angeordnetes Gate 16. Eine Wanne ist ein tiefreichendes Dotierungsgebiet mit deutlich höherer Dotierung als das Halbleitersubstrat. Das Anschlußgebiet 14 ist über eine Metalleiterbahn 12 mit dem Draingebiet des Transistors 1 verbunden, das Anschlußgebiet 15 über eine Metalleiterbahn 17 mit dem Ausgangsanschluß 8. Die Siliziumoberflächen des Widerstandes 2, d. h. die Anschlußgebiete 14, 15 und das Gate 16, sind ebenfalls mit einer Silizidschicht 11a, 11b, 11c bedeckt, die im gleichen Prozeßschritt wie die Silizidschicht 10a, 10b, 10c hergestellt wird. Der Transistor 1 und der Widerstand 2 sind an der Oberfläche des Halbleitersubstrats 3 bzw. der Wanne 13 von einer lokalen Oxidschicht 18 umgeben.

Der n-Kanal-Transistor 1 dient dazu, Überspannungsimpulse am Anschluß 8, die beispielsweise von einer elektrostatischen Entladung herrühren, zum Versorgungspotential VSS abzuleiten. Durch den Wannenwiderstand 2 wird der Stromfluß durch den Transistor 1 verringert. Der Wannenwiderstand ist dabei so zu dimensionieren, daß die Schalteigenschaften des Transistors in der Inverterstufe nur unwesentlich beeinflußt werden, der Stromfluß bei einer elektrostatischen Entladung jedoch soweit verringert wird, daß eine Zerstörung von Transistor 1 oder Widerstand 2 ausgeschlossen wird. Zwischen den Anschlußgebieten 14, 15 der Wanne 13 liegt das im wesentlichen als Widerstand wirksame Gebiet der Wanne 13. Der Widerstandswert kann durch die Dimensionierung des Abstands und der Dotierung der Wanne 13 eingestellt werden. Durch das zwischen den Anschlußgebieten 14, 15 angeordnete Gate ist die in diesem Bereich vorhandene Silizidschicht 11b nicht unmittelbar auf der Siliziumoberfläche der Wanne 13 angeordnet. Dadurch hat die Silizidschicht 11b keinen Einfluß auf den wirksamen Widerstandswert der Wanne 13. Das Gate 16 wird zusammen mit dem Gate 6 des Transistors 1 im gleichen Herstellungsschritt gefertigt. Dadurch ist kein zusätzlicher Herstellungsaufwand notwendig. Die Verwendung des Gates 16 hat prozeßtechnisch den Vorteil, daß dessen Länge, also der Abstand zwischen den Gebieten 14, 15, exakt kontrollierbar ist. Außerdem ist das Gate 16 die in ihrer Längsausdehnung kleinste Struktur, die kontrolliert hergestellt werden kann. Der Widerstandswert des Wannenwiderstandes 2 kann demnach relativ genau und mit geringem Flächenverbrauch realisiert werden.

In der Figur 2 ist eine verbesserte Ausführungsform der in der Figur 1 gezeigten Schutzstruktur angegeben. Gleiche Elemente sind dabei mit gleichen Bezugszeichen versehen. Das Draingebiet des Transistors 1 und das drainseitige Anscnlußgebiet des Wannenwiderstands 2 sind als ein zusammenhängendes Dotierungsgebiet 20 ausgebildet. Das Dotierungsgebiet 20 verläuft dabei über die Grenze zwischen Wanne 21 und Substrat 3. Die Schutzstruktur der Figur 2 ist ebenfalls ohne zusätzlichen prozeßtechnischen Aufwand realisierbar. Gegenüber der Ausführungsform nach Figur 1 wird weniger Siliziumfläche verbraucht. Außerdem entfällt die dort notwendige Metalleiterbahn 12.

Die bisher beschriebenen Ausführungsbeispiele enthalten als aktives Bauelement einen n-Kanal-Transistor, der direkt im p-leitenden Substrat 3 realisiert ist. Die Erfindung kann aber auch auf einen p-Kanal-Transistor und p-dotiertes Halbleitersubstrat angewendet werden. Ein solcher p-Kanal-Transistor ist bekanntermaßen in einer n-Wanne angeordnet. Der erfindungsgemäße Wannenwiderstand, der zwischen das p-leitende Draingebiet des p-Kanal-Transistors und den Ausgangsanschluß geschaltet ist, wird in entsprechender Weise zum Widerstand 2 der Figur 1 realisiert. Es liegen dann zwei Wannengebiete nebeneinander vor, von denen eines dem p-Kanal-Transistor, das andere dem zwischen Drain- und Ausgangsanschluß geschalteten Widerstand zugeordnet ist. Diese Lösung ist vorteilhaft, wenn nur ein Wannentyp mit dem Herstellungsprozeß hergestellt werden kann. Wenn mit einem Herstellungsprozeß zwei verschiedene Wannentypen realisierbar sind, die verschiedenen Leitungstyp und unterschiedliche Wannentiefen aufweisen, kann auch eine der Figur 2 entsprechende Ausführungsform einer Schutzstruktur mit einem p-Kanal-Transistor und einem p-Halbleitersubstrat realisiert werden. Dabei sind in der Wanne mit der größeren Wannentiefe sowohl die Drain- und Source-Gebiete des Transistors als auch die Wanne des Wannenwiderstands 2 enthalten.

Das Gate 16 des Widerstands 2 ist in den Figuren 1, 2 als nicht angeschlossen dargestellt. Das Gate folgt dann durch kapazitive Kopplung dem Drainpotential des Transistors 1.

Vorteilhafterweise wird dadurch das Gateoxid bei einem ESD-Ereignis relativ wenig belastet. Ebenso wie das Transistorgate 6 des Transistors 1 durch einen Metallkontakt 9 an einen Signalpfad angeschlossen ist, kann auch das Gate 16 des Widerstands 2 mit einem weiteren Schaltungsknoten verbunden werden. Hierfür ergeben sich jeweils unterschiedliche vorteilhafte Wirkungen. Das Gate des Widerstands 2 kann also entweder unverbunden sein, mit dem Gate des n-Kanal-Transistors verbunden werden, mit dem Ausgangsanschluß oder mit einem positiven Versorgungspotential VDD. Bei den drei zuletzt genannten Verbindungsmöglichkeiten wird bei Anlegen einer Spannung an das Gate des Widerstands 2 der Serienwiderstand der Wanne durch die Bildung einer Inversionsschicht unter dem Gate verringert. Dadurch wird die Schaltgeschwindigkeit der Ausgangsstufe erhöht, wenngleich die Festigkeit des Gateoxids gegenüber hohen ESD-Spannungen in akzeptablem Maße verringert wird.

Weitere Möglichkeiten, die Anschlußgebiete der Wanne und das Gate des Widerstands 2 zu verbinden, sind in der Figur 3a bis 3d gezeigt. Dabei ist die Ausgangsstufe aus den Transistoren 30, 31 zusammen mit dem Wannenwiderstand und dem Gate-Anschluß der erfindungsgemäßen Wanne gezeigt. Der n-Kanal-Transistor 30 ist mit dem Versorgungspotential VSS (Masse) verbunden, der p-Kanal-Transistor 31 mit dem bezüglich des Potentials VSS positivem Versorgungspotential VDD. Die Gateelektroden der Transistoren 30, 31 werden von einem an den Ausgang 8 auszugebenden Signal gesteuert. Beispielsweise können die Gate-Anschlüsse der Transistoren 30, 31 miteinander verbunden sein, so daß sich die Funktion eines Inverters ergibt. In der Figur 3a sind zwischen dem Drain-Anschluß des Transistors 30 und dem Ausgangsanschluß 8 der Wannenwiderstand 32 und das zugehörige Gate 33 wirksam. Das Gate 33 ist unverbunden, kann aber wie oben erwähnt vorteilhafterweise an den Gate-Anschluß des Transistors 30, den Ausgangsanschluß oder das Potential VDD angescnlossen werden.

Im Fall der Figur 3a wirkt der Widerstand 32 nur auf den Transistor 30. Um auch die ESD-Festigkeit des p-Kanal-Transistors 31 unter Verwendung der gleichen Wanne zu erhöhen, ist der Wannenwiderstand 34 (Figur 3b) und das zugehörige Gate 35 zwischen die Draingebiete beider Transistoren 30, 31 und den Ausgangsanschluß 8 geschaltet. Der Wannenwiderstand 34 wirkt hier als diskreter Widerstand auf die Transistoren 30, 31. Dies ist durch die entsprechenden Metallleiterbannen zu erreichen. Das Gate des Wannenwiderstands 34 kann dabei unverbunden bleiben oder mit dem Ausgangsanschluß 8, dem Verbindungsknoten 36 der Draingebiete der Transistoren 30, 31 oder dem Versorgungspotential VDD verbunden werden. Im ersten, unverbundenen Fall ist der Wannenwiderstand 34 derart zu dimensionieren, daß das Schaltvernalten der Ausgangsstufe nicnt wesentlich beeinträchtigt wird. Aufgrund der kapazitiven Kopplung zwischen Knoten 36 und Gate 35 ist die ESD-Festigkeit des Gateoxids des Gates 35 relativ hoch. Die drei letzteren Anschlußmöglichkeiten für das Gate 35 wirken sich weniger nachteilig auf die Schaltgeschwindigkeit der Ausgangsstufe aus. Wenn das Gate 35 mit dem Ausgangsanschluß 8 verbunden wird, wird das Entladen der Lastkapazität beim Umscnalten des Ausgangs auf einen H-Pegel begünstigt. Wenn das Gate 35 mit dem Knoten 36 verbunden wird, wird das Laden der Lastkapazität begünstigt. Im letztgenannten Fall der Verbindung des Gates 35 mit dem Potential VDD werden beide Lade- bzw. Entladevorgänge unterstützt.

Erfindungsgemäß ist es in einer weiteren Ausführungsform vorgesehen, daß zwischen dem Anschlußgebiet der Wanne anstelle eines Gates ein lokales Oxid entsprechend dem in der Figur 1 gezeigten lokalen Oxid 18 angeordnet ist. Auch dadurch wird gewährleistet, daß die Silizidschicht nicht direkt auf der zur Wanne gehörenden Siliziumoberfläche aufliegt. Die entsprechenden elektrischen Ersatzschaltbilder sind in den Figuren 3c und 3d gezeigt. In diesem Fall wirkt der Wannenwiderstand alleine als ohmscher Widerstand 37 bzw. 38. Durch geeignete Metalleiterbahnen, die mit den Anschlußgebieten der Wanne verbunden sind, kann der Widerstand entweder zwischen das Draingebiet eines Schalttransistors der Ausgangsstufe und den Ausgangsanschluß geschaltet werden (Figur 3c) oder aber zwischen die Draingebiete der beiden p- und n-Kanal Transistoren der Ausgangsstufe und den Ausgangsanschluß (Figur 3d). Auch durch diese Maßnahme wird die ESD-Festigkeit der Ausgangstransistoren bei Verwendung einer Silizidschicht erhöht, ohne daß zusätzliche Herstellungsschritte notwendig sind.

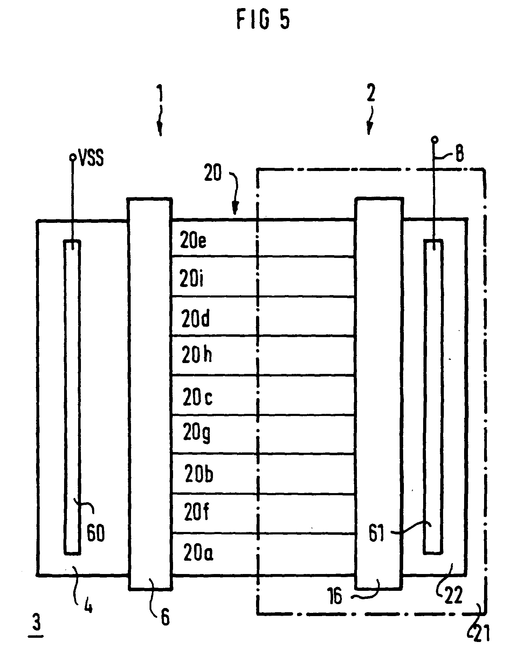

Ein weiteres Schutzelement gegen ESD-Ereignisse ist ein Dickoxidtransistor. In Figur 4 ist eine bekannte Anordnung mit einem Dickoxidtransistor gezeigt. Anstelle einer Gateelektrode bei einem MOS-Transistor ist beim Dickoxidtransistor ein lokales Oxid 50 oder Feldoxid vorhanden. Zu beiden Seiten des lokalen Oxids 50 sind Dotierungsgebiete 51, 52 entsprechend den Source- und Draingebieten eines MOS-Transistors angeordnet. Das Dotierungsgebiet 51 ist mit dem Potential VSS verbunden. Bei ESD-Belastung arbeitet der Dickoxidtransistor als ein im Lawinendurchbruch betriebener parasitärer npn-Bipolartransistor, wobei das Halbleitersubstrat 3 als Basis, die Dotierungsgebiete 52, 51 als Kollektor bzw. Emitter arbeiten. Ein Dickoxidtransistor wird vorzugsweise als Eingangsschutzstruktur verwendet, mit der ein Eingangsanschluß einer integrierten Schaltung vor ESD-Belastung geschützt wird.

Gemäß Figur 4b ist hierzu ein Eingang 60, der mit den Gateelektroden der Transistoren einer Eingangsschaltstufe 61 verbunden ist, über einen Dickoxidtransistor 62 mit dem Potential VSS verbunden. Dabei ist das eingangsseitig angeschlossene Dotierungsgebiet des Dickoxidtransistors 62 über einen Wannenwiderstand 63 an den Eingangsanschluß 60 angeschlossen. In der entsprechenden Beschaltung kann ein Dickoxidtransistor auch zum Schützen eines Ausgangsanschlusses verwendet werden.

Der Widerstand 63 ist als Wannenwiderstand realisiert. Hierzu ist in das p-dotierte Halbleitersubstrat 3 eine n-Wanne 53 eingebracht. Das transistorseitige n-Anschlußgebiet der Wanne bildet mit dem entsprechenden Dotierungsgebiet 52 des Transistors ein zusammenhängendes Dotierungsgebiet. Ein weiterer Wannenanschluß 54 ist über eine Metalleiterbahn 56 mit dem Eingangsanschluß 60 der integrierten Schaltung verbunden. Zwischen den n-Dotierungsgebieten 52, 54 ist ein weiterer lokaler Oxidabschnitt 55 angeordnet. Dabei wird durch das Oxid 55 vernindert, daß eine Silizidschicht unmittelbar auf der Siliziumoberfläcne der Wanne 53 aufliegt. Somit werden hohe lokale Strombelastungen und damit lokale Zerstörungen der Halbleiterstruktur vermieden.

Bei einem Dickoxidtransistor sind alle im Zusammenhang mit MOS-Transistoren aufgezeigten Ausführungen entsprechend anwendbar. Ein Dickoxidtransistor kann sowohl direkt im Halbleitersubstrat als auch als Dickoxidtransistor vom komplementären Leitungstyp in einer Wanne realisiert werden. Anstelle des lokalen Oxids 55 kann auch ein Transistorgate verwendet werden. Das Gate kann sowohl elektrisch angeschlossen als auch nicht angeschlossen werden. Ein schwebendes, also nicht angeschlossenes Gate ist besonders vorteilhaft, da dadurch der Serienwiderstand relativ hoch ist und somit die ESD-Festigkeit des Dickoxidtransistors erhöht wird. Da der Dickoxidtransistor nicht im Schaltbetrieb für die Signalverarbeitung verwendet wird, beeinflußt der hohe Serienwiderstand nicht den Schaltbetrieb. Ein weiteres Schutzelement, das vorzugsweise als Eingangsscnutzelement für eine integrierte Schaltung dient, ist ein Widerstand eines Dotierungsgebiets. Üblicherweise wird der Widerstand durch Diffusion erzeugt. Der Widerstandswert des diffundierten Widerstandes wird durch die auf die Siliziumoberfläche aufgebrachte Silizidschicht wesentlicn verringert. Durch die Realisierung des diffundierten Widerstandes mittels einer Wanne kann der Widerstandswert auf einen für den ESD-Schutz brauchbaren Wert eingestellt werden. Die Anschlußbereiche der Wanne sind durch ein lokales Oxid oder gemäß der Erfindung durch ein Gate voneinander getrennt.

In entsprechender Weise zu den obigen Ausführungen kann auch ein MOS-Transistor als Eingangsschutzstruktur verwendet werden, indem die Drain-Source-Strecke zwischen einen Eingangsanschluß und ein Versorgungspotential geschaltet ist. Zur Erhöhung der ESD-Festigkeit wird der MOS-Transistor mit einem Wannenwiderstand in Reihe geschaltet.

In Figur 5 ist die Aufsicht auf eine erfindungsgemäße Schutzstruktur, beispielsweise der Schutzstruktur gemäß Figur 2, gezeigt. Gleiche Elemente sind mit gleichen Bezugszeichen versehen. Der MOS-Transistor 1 ist dabei mit dem Widerstand 2 gezeigt, der in der Wanne 21 angeordnet ist. Transistor und Wanne sind in der dargestellten vertikalen Richtung längs ausgedehnt. In den Dotierungsgebieten 4, 22 sind die entsprechenden Metallkontakte 60 bzw. 61 zum Anschluß an das Versorgungspotential VSS bzw. den Ausgangsanschluß 8 gezeigt. Das Dotierungsgebiet 20, das als Draingebiet des Transistors 1 und Anschlußgebiet der Wanne 21 dient, ist an der Oberfläche streifenförmig ausgebildet. Die Oberfläche des Diffusionsgebiets weist Streifen 20a bis 20i auf, die sich vom Transistorgate 6 zum Gate 16 des Wannenwiderstands erstrecken. Die Streifen 20a bis 20e sind mit einer Silizidschicht bedeckt. Zwischen zwei benachbarten Streifen 20a bis 20e liegt je ein streifenförmiges Gebiet 20f bis 20i des Dotierungsgebiets 20, das an der Oberfläche mit einer lokalen Oxidschicht bedeckt ist. Dadurch wird verhindert, daß in den Streifen 20f bis 20i des Dotierungsgebiets 20 eine Silizidschicht auf der Siliziumoberfläche liegt.

Wenn ein lokaler Durchbruch an der Sperrschicht zwischen dem Dotierungsgebiet 20 und dem Halbleitersubstrat 3 im Bereich der Gateelektrode 6 in einem der mit Silizid bedeckten Streifen 20a bis 20e auftritt, ist nur der Stromanteil betroffen, der durch diesen Streifen fließt. Durch die streifenförmige Ausbildung ist der längs eines Streifens wirksame Widerstand im Vergleich zu einer Ausbildung ohne Streifen erhöht. Dieser Stromanteil erzeugt längs des Streifens einen Spannungsabfall, durch den auch die parallel liegenden Streifen ebenfalls in den Durchbruch getrieben werden können, bis der gesamte Transistor im Durchbruch betrieben wird. Durch die Verteilung des Stroms auf die gesamte Breite der Grenzschicht ergibt sich eine im Vergleich zu einem lokal eng begrenzten Durchbruchbereich wesentlich erhöhte Durchbruchspannung und somit erhöhte ESD-Festigkeit. Für die anderen, nicht im Durchbruch befindlichen Streifen des Dotierungsgebiets 20 arbeitet die entsprechende Sperrscnicnt ungestört in der normalen Transistorfunktion. Durch die streifenförmige Ausführung der Oberfläche des Dotierungsgebiets 20 wird somit vorteilhafterweise verhindert, daß sich bei einem lokalen Durchbruch eine Stromkonzentration auf ein eng begrenzten Durchbruchsbereich einstellt. Für jeden der Abschnitte 20a bis 20i des Dotierungsbebiets 20 wirkt somit der Wannenwiderstand mit dem dem Streifen anteilig zugeordneten Widerstandsabschnitt.

Die Unterbrechung der Silizidschicht an der Oberfläche des Dotierungsgebiets 20 kann sowohl mit einem Gate als auch mit der in der Figur 5 gezeigten lokalen Oxidschicht erfolgen. Diese Unterbrechung, entweder mit einem lokalen Oxid oder einem Gate, kann auf Dickoxidtransistoren und MOS-Transistoren bei Ausführung des Wannenwiderstandes sowohl mit einer lokalen Oxidschicht als auch mit einem Gate gleichermaßen angewendet werden. Bei Verwendung von Transistorgates zur Erzeugung der Streifen des Dotierungsgebiets 20 kann dieses Gate mit dem Gate 6 des Transistors 1 verbunden und wahlweise zusätzlich durch Metalleiterbahnen entsprechend dem Transistorgate 6 angeschlossen werden.

## Patentansprüche

1. Schutzstruktur gegen elektrostatische Entladungen für integrierte Halbleiterschaltungen enthaltend:
(a) einen zu schützenden Anschluß (8) der integrierten Schaltung,
(b) ein Halbleiterbauteil (1), das zwischen den Anschluß (8) der integrierten Schaltung und einen Anschluß für ein Versorgungspotential (VSS) geschaltet ist und das ein Dotierungsgebiet (5) aufweist, das an den Anschluß (8) der integrierten Schaltung anschließbar ist,
(c) einen Widerstand (2), der als Wannendotierungsgebiet (13) realisiert ist und der zwischen das Dotierungsgebiet (5) des Halbleiterbauteils (1) und den Anschluß (8) der integrierten Schaltung geschaltet ist,
(d) wobei das Wannendotierungsgebiet (13) ein erstes Anschlußdotierungsgebiet (14) zum Anschließen an das Dotierungsgebiet (5) des Halbleiterbauteils (1) und ein zweites Anschlußdotierungsgebiet (15) zum Anschließen an den Anschluß (8) der integrierten Schaltung aufweist,
(e) wobei zwischen den Anschlußdotierungsgebieten (14, 15) ein Transistorgate (16) angeordnet ist, und
(f) wobei das erste und zweite Anschlußdotierungsgebiet (14,15) den glichen Leitfähigkeitstyp aufweisen wie das Wannendotierungsgebiet (13).

2. Schutzstruktur nach Anspruch 1,
**dadurch gekennzeichnet,**
**daß** das erste Anschlußdotierungsgebiet (14) und das Dotierungsgebiet (5) des Halbleiterbauteils (1) ein zusammenhängendes Dotierungsgebiet (20) bilden.

3. Schutzstruktur nach Anspruch 2,
**dadurch gekennzeichnet,**
**daß** das zusammenhängende Dotierungsgebiet (20) an der Siliziumoberfläche ausgebildete Streifen aufweist, die abwechselnd aus Silizid (20a, ..., 20e) und einem Transistorgate (20f, ..., 20i) bestehen.

4. Schutzstruktur nach Anspruch 3,
**dadurch gekennzeichnet,**
**daß** das zusammenhängende Dotierungsgebiet (20) an der Siliziumoberfläche Streifen aufweist, die abwechselnd aus Silizid (20a, ..., 20e), und einem lokalen Oxid bestehen.

5. Schutzstruktur nach einem der Ansprüche 2 bis 4,
**dadurch gekennzeichnet,**
**daß** das Halbleiterbauteil (1) ein MOS-Transistor ist.

6. Schutzstruktur nach einem der Ansprüche 2 bis 4,
**dadurch gekennzeichnet,**
**daß** das Halbleiterbauelement (1) ein Dickoxidtransistor (50, 51, 52) ist.

## Claims

1. Protective structure against electrostatic discharges for integrated semiconductor circuits, containing:
(a) a connection (8) of the integrated circuit, which connection needs to be protected,
(b) a semiconductor component (1) which is connected between the connection (8) of the integrated circuit and a connection for a supply potential (VSS) and which has a doping region (5) which can be connected to the connection (8) of the integrated circuit,
(c) a resistor (2) which is produced in the form of a well doping region (13) and which is connected between the doping region (5) of the semiconductor component (1) and the connection (8) of the integrated circuit,
(d) the well doping region (13) having a first connection doping region (14) for connecting it to the doping region (5) of the semiconductor component (1) and having a second connection doping region (15) for connecting it to the connection (8) of the integrated circuit,
(e) a transistor gate (16) being arranged between the connection doping regions (14, 15), and,
(f) the first and second connection doping regions (14, 15) having the same conductivity type as the well doping region (13).

2. Protective structure according to Claim 1,
**characterized**
**in that** the first connection doping region (14) and the doping region (5) of the semiconductor component (1) form a cohesive doping region (20).

3. Protective structure according to Claim 2,
**characterized**
**in that** the cohesive doping region (20) has strips which are produced on the silicon surface and alternately comprise silicide (20a, ... ,20e) and a transistor gate (20f, ... , 20i).

4. Protective structure according to Claim 3,
**characterized**
**in that** the cohesive doping region (20) has strips on the silicon surface which alternately comprise silicide (20a, ... ,20e) and a local oxide.

5. Protective structure according to one of Claims 2 to 4,
**characterized**
**in that** the semiconductor component (1) is an MOS transistor.

6. Protective structure according to one of Claims 2 to 4,
**characterized**
**in that** the semiconductor component (1) is a thick-oxide transistor (50, 51, 52).

## Revendications

1. Structure de protection vis-à-vis des décharges électrostatiques pour des circuits intégrés à semi-conducteur comprenant :
(a) une borne (8) à protéger du circuit intégré ;
(b) un composant (1) à semi-conducteur, qui est monté entre la borne (8) du circuit intégré et une borne pour un potentiel (VSS) d'alimentation et qui comporte une zone (5) de dopage qui peut être reliée à la borne (8) du circuit intégré ;
(c) une résistance (2) qui est réalisée en zone (13) de dopage à cuvette et qui est interposée entre la zone (5) de dopage du composant (1) à semi-conducteur et la borne (8) du circuit intégré ;
(d) la zone (13) de dopage à cuvette comportant une première zone (14) de dopage de borne destinée au raccordement à la zone (5) de dopage du composant (1) à semi-conducteur et une deuxième zone (15) de dopage de borne destinée au raccordement à la borne (8) du circuit intégré ;
(e) une grille (16) de transistor est disposée entre les zones (14, 15) de dopage de borne et
(f) la première et la deuxième zones (14, 15) de dopage de borne ont le même type de conductivité que la zone (13) de dopage de cuvette.

2. Structure de protection selon la revendication 1, **caractérisée en ce que** la première zone (14) de dopage de borne et la zone (5) de dopage du composant (1) à semi-conducteur forment une zone (20) de dopage continue.

3. Structure de protection selon la revendication 2, **caractérisée en ce que** la zone (20) de dopage continu comporte des bandes qui sont constituées sur la surface en siliciure et qui sont constituées alternativement de siliciure (20a, ..., 20 e) et d'une grille (20f, ..., 20i) de transistor.

4. Structure de protection selon la revendication 3, **caractérisée en ce que** la zone (20) de dopage continu comporte sur la surface de siliciure des bandes qui sont constituées alternativement en siliciure (20a, ..., 20 e) et en un oxyde local.

5. Structure de protection selon l'une des revendications 2 à 4, **caractérisée en ce que** le composant (1) à semi-conducteur est un transistor MOS.

6. Structure de protection selon l'une des revendications 2 à 4, **caractérisée en ce que** le composant (1) à semi-conducteur est un transistor (50, 51, 52) à oxyde épais.
